# EUROPEAN PATENT APPLICATION

(11) **EP 4 270 669 A1**
(43) Date of publication of application: **01.11.2023**
(21) Application number: 22749215.4
(22) Date of filing: 30.01.2022
(51) Int. Cl.: H01R 12/79, H01R 13/02

(54) **INTERFACE BOARD INTERCONNECTION DEVICE**

(30) Priority: 03.02.2021 CN 202110150101
(71) Applicant: Huawei Technologies Co., Ltd., Shenzhen, Guangdong 518129 (CN)
(72) Inventor: CAO, Shuzhao, Shenzhen, Guangdong 518129 (CN); HU, Bin, Shenzhen, Guangdong 518129 (CN)
(74) Representative: Pfenning, Meinig & Partner mbB
(86) International application number: PCT/CN2022/075252
(87) International publication number: WO 2022/166936

(57) **Abstract**

Disclosed is an interface board interconnection apparatus, to improve reliability of signal transmission of a connector. The apparatus includes: a meltable conductive solid (2111) disposed on a pin (211) of a connector (21) or in a connection hole (221) of a PCB (22). The meltable conductive solid (2111) after being melted and solidified may fasten the pin (211) to the connection hole (221) of the PCB (22).

## Description

This application claims priority to Chinese Patent Application No. 202110150101.7, filed with the China National Intellectual Property Administration on February 3, 2021 and entitled "INTERFACE BOARD INTERCONNECTION APPARATUS", which is incorporated herein by reference in its entirety.

### TECHNICAL FIELD

Embodiments of this application relate to the field of connector technologies, and in particular, to an interface board interconnection apparatus.

### BACKGROUND

A connector is a bridge for communication at a blocked part in a circuit or between isolated circuits, thereby enabling a current to flow and enabling a circuit to implement a predetermined function. As a capacity of a communication product increases, more information is exchanged between different circuits. A transmission rate of a connector needs to be continuously improved, gradually from 56 Gbps (Gbps) to 112 Gbps+. Package crosstalk of a printed circuit board (printed circuit board, PCB) becomes a main obstacle for rate improvement. In this case, a manner of assembling connectors at higher density must be used to implement the rate improvement. As a press-fit hole diameter for a pin of a connector and a PCB decreases, for example, the press-fit hole diameter decreases to 0.30 millimeters (mm) or less, there may be a problem of an insufficient retention force between the pin of the connector and the PCB. This causes a problem of component drop of the connector or even a problem of reduced reliability of an electrical connection between the connector and the PCB.

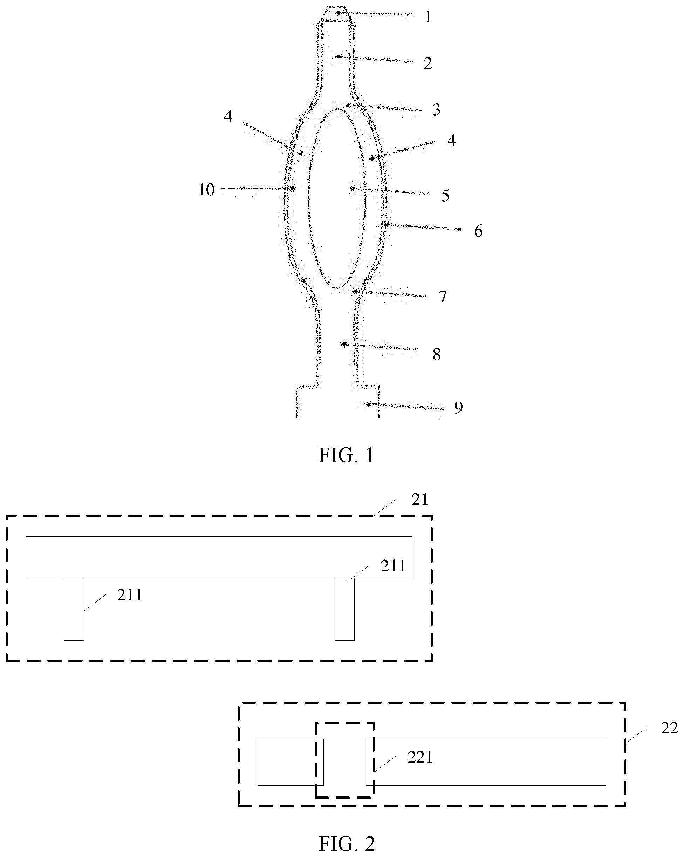

Refer to a schematic diagram of a structure of a "fisheye" press-fit terminal shown in FIG. 1. The pin of the connector may be shown as the press-fit terminal. The press-fit terminal includes regions 1 to 10. The region 1 is a tip part of the "fisheye" terminal, and enters a hole first during a press-fit process. A region 2 is a far-end part of the "fisheye" terminal, and is in clearance fit with a press-fit hole. A region 3 is a lower edge part of the "fisheye" terminal, and starts to be in contact with the hole during the press-fit process. A region 4 is a beam structure part of the "fisheye" terminal, and is in elastic contact with the press-fit hole and deformed. A region 5 is an opening of the "fisheye" terminal, and provides space for the elastic deformation of the beam. A region 6 is a chamfer of the "fisheye" terminal, and may reduce press-in pressure and prevent hole copper from being damaged. A region 7 is an upper edge part of the "fisheye" terminal, and is not in full elastic contact with the hole after being pressed in a board. A region 8 is a neck of the "fisheye" terminal. A region 9 is a shoulder of the "fisheye" terminal. The region 10 is a middle position of the "fisheye" terminal. Press-fit at a small hole diameter is implemented through fitting between the "fisheye" terminal structure and the press-fit hole.

However, a retention force of a "fisheye" of the "fisheye" press-fit terminal is insufficient. To be specific, the retention force is less than 2.0 N/pin (N/pin). As a result, there is a risk of unreliable signal transmission in the connector.

### SUMMARY

This application provides an interface board interconnection apparatus, to improve reliability of signal transmission of a connector.

According to a first aspect of this application, an interface board interconnection apparatus is provided. The apparatus includes a connector and a printed circuit board PCB. A pin is disposed on the connector. A connection hole is disposed on the PCB. The pin is connected to the connection hole. A meltable conductive solid is disposed on the pin, and the meltable conductive solid is configured to be melted and solidified when the pin is placed in the connection hole, to fasten the pin and the connection hole. Alternatively, a meltable conductive solid is disposed in the connection hole, and the meltable conductive solid is configured to be melted and solidified when the pin is placed in the connection hole, to fasten the pin and the connection hole.

In the first aspect, the meltable conductive solid is disposed on the pin in advance or the meltable conductive solid is disposed in the connection hole in advance. The melted meltable conductive solid is enabled to fill a clearance between the pin and the connection hole at a preset temperature, and to fasten the pin and the connection hole after being cooled. Therefore, a problem of insufficient connection strength of a "fisheye" press-fit terminal can be avoided. In addition, a structure damage caused to the connector by direct soldering of the pin and the connection hole can be avoided, and reliability of signal transmission of the connector can be improved.

In a possible implementation, the meltable conductive solid is a solder paste or a conductive adhesive.

In a possible implementation, the conductive adhesive is a glue material including copper, silver, or gold.

In the foregoing implementation, the conductive adhesive may include a metal material, so that the connector is electrically connected to the PCB.

In a possible implementation, the solder paste is a low-temperature solder paste, a medium-temperature solder paste, or a high-temperature solder paste.

In a possible implementation, a hole diameter of the connection hole is less than 0.30 mm.

In a possible implementation, the meltable conductive solid is melted at a low temperature, a medium temperature, or a high temperature.

In a possible implementation, the pin is of a curved structure, a spring structure, or a tapered structure.

In the foregoing implementation, the curved structure may increase a bonding force between the pin and the meltable conductive solid, and a curved part of the pin may also interfere with a hole wall, so that connection strength of the connector and the PCB is improved. A strong bonding force between the pin and the meltable conductive solid can be improved by using the spring structure. The tapered structure may be used in a connection hole with a smaller hole diameter.

In a possible implementation, the connection hole is a through hole or a stepped hole.

In the foregoing implementation, for the through hole, it is easy to process, but there is a risk of solder leakage/conductive adhesive leakage; and for the stepped hole, it is easier to implement air exhaustion and to form a solder j oint, but it is difficult to process a PCB.

In a possible implementation, a cross section of the pin is in a shape of any one of a circle, an ellipse, a waist drum, a square, a rectangle, and a teardrop.

In a possible implementation, a barb is disposed on the pin.

In the foregoing implementation, a capability of binding the pin to the meltable conductive solid can be improved.

### BRIEF DESCRIPTION OF DRAWINGS

FIG. 1 is a schematic diagram of a structure of a "fisheye" press-fit terminal according to an embodiment of this application;
FIG. 2 is a schematic diagram of an architecture of a connector and a PCB according to an embodiment of this application;
FIG. 3 is a schematic diagram of an interface board interconnection apparatus according to an embodiment of this application;
FIG. 4 is a schematic diagram of a process of fastening a connector to a PCB according to an embodiment of this application;
FIG. 5 is a schematic diagram of another interface board interconnection apparatus according to an embodiment of this application;
FIG. 6 is another schematic diagram of a process of fastening a connector to a PCB according to an embodiment of this application;
FIG. 7 is a schematic diagram of a structure of a stepped hole according to an embodiment of this application;
FIG. 8 is a schematic diagram of a curved structure according to an embodiment of this application;
FIG. 9 is a schematic diagram of a spring structure according to an embodiment of this application; and
FIG. 10 is a schematic diagram of a tapered structure according to an embodiment of this application.

### DESCRIPTION OF EMBODIMENTS

This application provides an interface board interconnection apparatus, to improve reliability of signal transmission of a connector.

The following describes embodiments of this application with reference to accompanying drawings. It is clear that the described embodiments are merely some but not all of embodiments of this application. Persons of ordinary skill in the art may learn that, with development of technologies and emergence of new scenarios, the technical solutions provided in embodiments of this application are also applicable to a similar technical problem.

In the specification, claims, and accompanying drawings of this application, the terms such as "first" and "second" are intended to distinguish between similar objects but do not necessarily indicate a specific order or sequence. It should be understood that the data termed in such a way are interchangeable in proper circumstances, so that embodiments described herein can be implemented in an order other than the content illustrated or described herein. Moreover, the terms "include", "contain", and any other variant thereof are intended to cover a non-exclusive inclusion. For example, a process, method, system, product, or device that includes a list of steps or units is not necessarily limited to those steps or units that are expressly listed, but may include other steps or units that are not expressly listed or are inherent to the process, method, product, or device.

The specific term "example" herein means "used as an example, embodiment, or illustration". Any embodiment described as an "example" is not necessarily explained as being superior or better than other embodiments.

In addition, to better describe this application, numerous specific details are given in the following specific implementations. Persons skilled in the art should understand that this application can also be implemented without some specific details. In some instances, methods, means, elements, and circuits that are well-known to persons skilled in the art are not described in detail, so that a subject of this application is highlighted.

FIG. 2 is a schematic diagram of an architecture of a connector and a PCB. The architecture includes a connector 21 and a printed circuit board (printed circuit board, PCB) 22. The connector 21 further includes pins 211. The PCB 22 further includes a connection hole 221. Therefore, the pin 211 can be inserted into the PCB 22 with the connection hole 221, and the connector 21 is connected to the PCB 22 through a connection relationship between the connection hole 221 and the pin 211.

As a capacity of a communication product increases, more information is exchanged. A transmission rate of a connector also needs to be continuously improved. In this case, a manner of assembling connectors at higher density must be used to implement the rate improvement. In other words, a size of the pin and a hole diameter of the connection hole need to be smaller. When the hole diameter of the connection hole is reduced to 0.30 mm or less, a problem of an insufficient retention force between the pin and the connection hole may be caused. This causes a problem of component drop of the connector or even a problem of reduced reliability of an electrical connection between the connector and the PCB. In addition, it is difficult to implement stamping for a "fisheye" press-fit terminal. A requirement for precision is high. A tolerance of a processing capability for mass production of a critical dimension of a fisheye is improved from ±0.03 mm to at least ±0.015 mm.

To resolve the foregoing problem, an embodiment of this application provides an interface board interconnection apparatus. The apparatus is specifically described as follows.

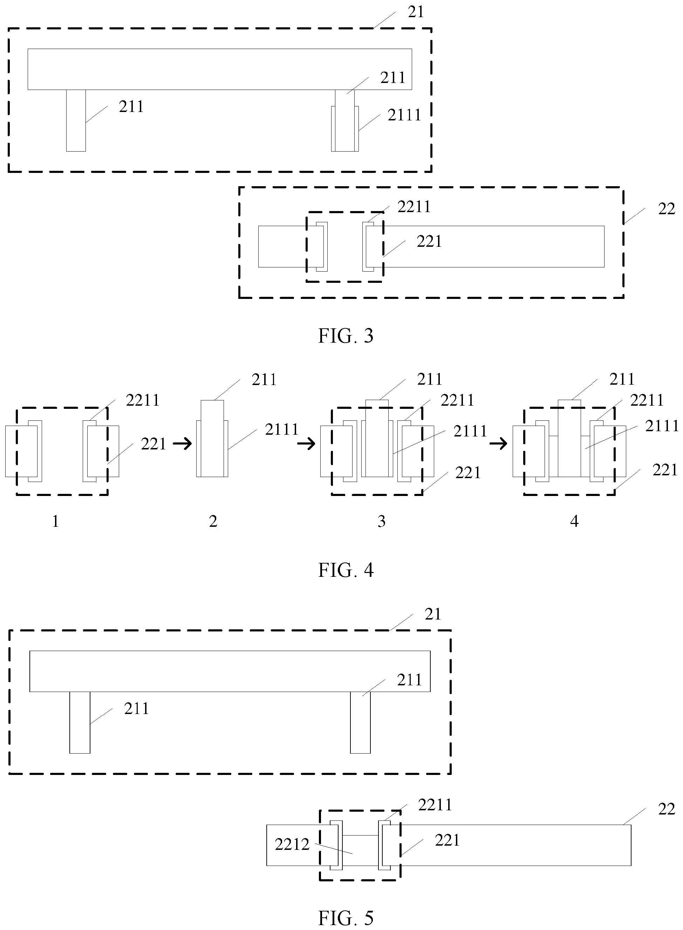

FIG. 3 is a schematic diagram of an interface board interconnection apparatus according to this application. As shown in FIG. 3, a meltable conductive solid 2111 is disposed on a pin 211 in an assembly or adhesion manner, and a conductive material 2211 is disposed in a connection hole 221. The conductive material 2211 is configured to connect to the meltable conductive solid 2111 on the pin 211 in a melting manner after the pin 211 is inserted into the connection hole 221, so that the pin 211 is fastened by using the melted meltable conductive solid 2111 and the pin 211 can also be connected to the PCB 22. The connector 21 is a new high-speed connector.

Specifically, a process of fastening the connector 21 and the PCB 22 may be shown in FIG. 4. In this embodiment, the pin 211 and the connection hole 221 are used as an example. As shown in FIG. 4, in a first step, the connection hole 221 is generated by drilling into the PCB, and then the conductive material 2211 is disposed in the connection hole 221. The conductive material 2211 may be metal such as copper or gold, and a layer of a metal material such as copper or gold is disposed in the connection hole 221 through electroless copper plating, gold plating, or the like. In a second step or a step that may be performed in parallel with the first step, the meltable conductive solid 2111 is pre-configured on the pin 211. Optionally, the meltable conductive solid 2111 may be a solder paste, a conductive adhesive, or the like, or may be another meltable conductive solid. This is not specifically limited herein. In a third step, the pin 211 on which the meltable conductive solid 2111 is disposed in advance is inserted into the connection hole 221. In a fourth step, the connector and the PCB that are assembled may be placed at a preset temperature, so that the meltable conductive solid 2111 is melted and fully fills a clearance between the pin 211 and the conductive material 2211. Therefore, the pin 211 is fully bonded to the connection hole 221, so that the connector and the PCB are electrically interconnected, thereby obtaining sufficient connection strength. Optionally, the preset temperature may be a low temperature, a medium temperature, or a high temperature that can be later implemented.

Optionally, the interface board interconnection apparatus in this embodiment may be used not only to a connection hole with a small hole diameter (less than 0.30 mm), but also to a connection hole with a hole diameter greater than 0.30 mm.

Optionally, the solder paste may be a low-temperature solder paste or a medium-temperature solder paste. Generally, a preset temperature of a reflow oven is about 40°C higher than a melting point of the solder paste. Correspondingly, different preset temperatures are used to melt the solder paste. Optionally, when structures of the connector and the PCB are not affected in a high-temperature environment later, the solder paste may be alternatively a high-temperature solder paste.

Optionally, the conductive adhesive may be a glue material including metal such as copper, silver, or gold.

In this embodiment of this application, the meltable conductive solid may be disposed on the pin in advance, as described above, or the meltable conductive solid may be disposed in the connection hole in advance. For details, refer to the following description.

FIG. 5 is a schematic diagram of another interface board interconnection apparatus according to this application. As shown in FIG. 5, the meltable conductive solid 2212 is melted into the connection hole 221 in advance. The pin 211 is inserted into the melted meltable conductive solid 2212 at a preset temperature, and is fastened in the meltable conductive solid 2212 after being cooled, so that the connector 21 is connected to the PCB 22.

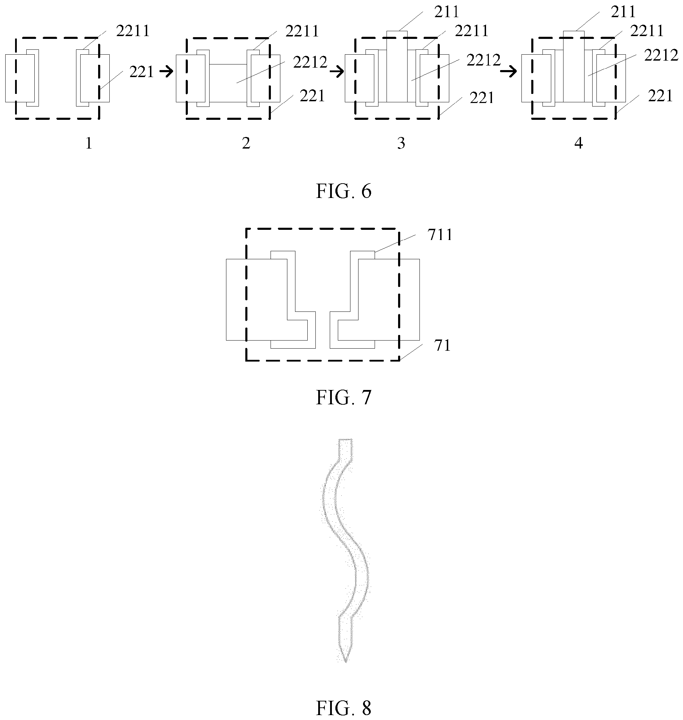

Specifically, a process of fastening the connector 21 and the PCB 22 may be shown in FIG. 6. In this embodiment, the pin 211 and the connection hole 221 are used as an example. As shown in FIG. 6, in a first step, for the connection hole 221 and the conductive material 2211, refer to the related description in the first step in FIG. 4. Details are not described herein again. In a second step, the meltable conductive solid 2212 may be melted in the connection hole 221. Optionally, solder/a conductive adhesive may be dispensed in the connection hole 221 by using a solder/an adhesive dispensing device. The solder and the conductive adhesive fill most space in the connection hole 221. In a third step, because the meltable conductive solid 2212 is a paste-like or glue-like object prone to penetration, the pin 211 may be inserted into the connection hole 221 through penetrating. In a fourth step, the connector and the PCB that are assembled are placed at a preset temperature, so that the meltable conductive solid 2111 is melted. The melted meltable conductive solid 2212 can be fully bonded to the pin, so that the connector and the PCB are electrically interconnected. According to the embodiment of this application, the following problem can be avoided: A structure the connector is prone to damage due to soldering, and the PCB is also damaged due to a heat capacity problem.

Optionally, in this embodiment, the connection hole 221 may be a through hole in FIG. 3 to FIG. 6. For the through hole, there may be a risk that the solder paste or the conductive adhesive flows out from a back side, but it is easy to process in the PCB. The connection hole 221 may be alternatively another type of hole, for example, a stepped hole. As shown in FIG. 7, the stepped hole 71 uses a structure including a large hole and a small hole. To be specific, a through hole with a wide upper part and a narrow lower part is made on the PCB through drilling to provide a path for flux volatilization and ensure smooth formation of a solder j oint. The solder paste or the conductive adhesive can fill most space of the through hole. The narrow lower part of the through hole is small enough (for example, less than 0.1 mm), and can be used for air exhaustion while ensuring that the solder paste or the conductive adhesive does not flow out. Likewise, a conductive material 711 is disposed in the stepped hole.

Optionally, a cross section of the pin may be, for example, in a shape of any one of a circle, an ellipse, a waist drum, a square, a rectangle, and a teardrop. This is not limited thereto. The pin can be processed into various needed shapes according to actual production and process requirements. The pin is flexible in structure.

Optionally, a barb may be further disposed on the pin. The bard may be specifically disposed in the middle or at the bottom, to improve a bonding force between the pin and the solder paste or the conductive adhesive.

Optionally, in addition to a straight pin structure shown in FIG. 3 to FIG. 6, the pin may be alternatively of a curved structure, a spring structure, or a tapered structure.

Specifically, in a curved structure shown in FIG. 8, a maximum width of the curved structure is less than a diameter of the through hole or less than a diameter of the large hole in the stepped hole. The curved shape facilitates improvement of the bonding force between the pin and the solder paste or the conductive adhesive. In this case, a curved part of the pin may be designed to interfere with a hole wall to improve connection strength, so that a double-insurance design is provided together with combination of the solder paste and the pin.

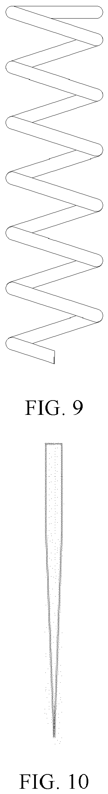

In a spring structure shown in FIG. 9, a maximum width of the spring structure is less than a diameter of the through hole or less than a diameter of the large hole in the stepped hole. Stronger connection strength can be provided by using the spring structure than the curved structure in FIG. 8. In other words, the bonding force between the pin and the solder paste or the conductive adhesive is greatly improved by using the spring curved structure.

In a tapered structure shown in FIG. 10, a maximum width of the tapered structure is less than a diameter of the through hole or less than a diameter of the large hole in the stepped hole. The tapered structure may be used in a connection hole with a smaller hole diameter.

It may be clearly understood by persons skilled in the art that, for the purpose of convenient and brief description, for a detailed working process of the foregoing systems, apparatuses, and units, reference may be made to a corresponding process in the foregoing method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on a plurality of network elements. Some or all of the units may be selected according to actual requirements to achieve the objectives of the solutions of the embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit.

In conclusion, the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. An interface board interconnection apparatus, comprising a connector and a printed circuit board PCB, wherein a pin is disposed on the connector, a connection hole is disposed on the PCB, and the pin is connected to the connection hole; and
a meltable conductive solid is disposed on the pin, and the meltable conductive solid is configured to be melted and solidified when the pin is placed in the connection hole, to fasten the pin and the connection hole; or
a meltable conductive solid is disposed in the connection hole, and the meltable conductive solid is configured to be melted and solidified when the pin is placed in the connection hole, to fasten the pin and the connection hole.

2. The interface board interconnection apparatus according to claim 1, wherein the meltable conductive solid is a solder paste or a conductive adhesive.

3. The interface board interconnection apparatus according to claim 2, wherein the conductive adhesive is a glue material comprising copper, silver, or gold.

4. The interface board interconnection apparatus according to either of claims 2 and 3, wherein the solder paste is a low-temperature solder paste, a medium-temperature solder paste, or a high-temperature solder paste.

5. The interface board interconnection apparatus according to any one of claims 1 to 3, wherein a hole diameter of the connection hole is less than 0.30 mm.

6. The interface board interconnection apparatus according to any one of claims 1 to 3, wherein the meltable conductive solid is melted at a low temperature, a medium temperature, or a high temperature.

7. The interface board interconnection apparatus according to any one of claims 1 to 3, wherein the pin is of a curved structure, a spring structure, or a tapered structure.

8. The interface board interconnection apparatus according to any one of claims 1 to 3, wherein the connection hole is a through hole or a stepped hole.

9. The interface board interconnection apparatus according to any one of claims 1 to 3, wherein a cross section of the pin is in a shape of any one of a circle, an ellipse, a waist drum, a square, a rectangle, and a teardrop.

10. The interface board interconnection apparatus according to any one of claims 1 to 3, wherein a barb is disposed on the pin.
